# EUROPEAN PATENT APPLICATION

(11) **EP 2 682 839 A2**
(43) Date of publication of application: **08.01.2014**
(21) Application number: 13174658.8
(22) Date of filing: 02.07.2013
(51) Int. Cl.: G06F 1/16, G06F 1/20, H01L 51/52, H01L 27/32, H05K 7/20

(54) **Display apparatus**

(30) Priority: 04.07.2012 KR 20120073117
(71) Applicant: Samsung Electronics Co., Ltd, Gyeonggi-do 443-742 (KR)
(72) Inventor: In, Woo Sung, Gyeonggi-do (KR); Kim, Sung Ki, Seoul (KR); Kim, Sru, Gyeonggi-do (KR); Paek, Byung Joo, Gyeonggi-do (KR); Cho, Jin Hyun, Seoul (KR); Kim, Yong Jin, Seoul (KR)
(74) Representative: Robinson, Ian Michael

(57) **Abstract**

A display apparatus is provided. The display apparatus includes: a display panel 10 which displays an image on a front surface thereof; and a heat spreading module 20 having a shape corresponding to the display panel 10 to support a rear surface, opposite the front surface, of the display panel, wherein the heat spreading module 20 includes a heat spreader 21 including a working fluid 21b therein and at least one channel 21a provided therein to guide the working fluid 21 b.

## Description

### BACKGROUND

### 1. Field

Apparatuses and methods consistent with exemplary embodiments relate to a display apparatus which may improve heat dissipation.

### 2. Description of the Related Art

A display apparatus is a device that displays an image on a screen. Examples of the display apparatus include televisions (TVs) and computer monitors.

Recently, a flat panel display apparatus has been developed to replace cathode-ray tube (CRT) display apparatuses, achieving slim design, light weight, and low power consumption.

Flat panel display apparatuses may be broadly classified into a light-emitting type and a light-receiving type. Flat panel display apparatuses of the light-emitting type include plasma display panels (PDPs) and organic light emitting diode (OLED) display panels. Flat panel display apparatuses of the light- receiving type include liquid crystal displays (LCDs).

Among display apparatuses, display apparatuses employing OLEDs provide better luminance and wider viewing angle than LCDs and do not need a backlight unit, and thus may be implemented in a super slim design.

### SUMMARY

One or more exemplary embodiments provide a display apparatus which may increase heat dissipation by more effectively distributing heat generated in operation of the apparatus. Other aspects and advantages will be set forth in the description which follows and/or will be apparent from the description, and/or may be learned from practice of exemplary embodiments.

According to the present invention there is provided a display apparatus as set forth in claim 1. Other features of the invention are set forth in the dependent claims and/or in the following description.

In one example, there is provided a display apparatus including: a display panel which displays an image on a front surface thereof; and a heat spreading module having a shape corresponding to the display panel to support a rear surface, opposite the front surface, of the display panel, wherein the heat spreading module includes a heat spreader including a working fluid therein and at least one channel provided therein to guide the working fluid.

The display panel may be an organic light emitting diode panel.

The display apparatus may further include at least one printed circuit board on a rear surface of the heat spreading module.

A length of the heat spreader may be greater than a width of the heat spreader.

The heat spreading module may include a plurality of heat spreaders, including the heat spreader, connected to each other in a widthwise direction thereof.

A length of heat spreading module may correspond to a horizontal width of the display panel, and the plurality of the heat spreaders may be vertically connected to each other to correspond to the vertical width of the display panel.

Lengths of the plurality of the heat spreaders may correspond to a vertical width of the display panel, and the plurality of the heat spreaders may be connected to each other in the widthwise direction thereof to correspond to a horizontal width of the display panel.

First heat spreaders, of the plurality of the heat spreaders, may be connected to each other in a longitudinal direction, perpendicular to the widthwise direction, thereof to form an array having a length corresponding to a horizontal width of the display panel, the heat spreading module may include a plurality of arrays of heat spreaders connected to each other in the widthwise direction thereof to correspond to a vertical width of the display panel, and the plurality of arrays may be connected such that connecting portions in which heat spreaders are connected in one of the arrays are misaligned with connecting portions in an adjacent one of the arrays.

The at least one channel may extend in a longitudinal direction of the heat spreader, and a plurality of the channels is arranged in the widthwise direction of the at least one heat spreader.

The heat spreading module may include a reinforcing frame on a same plane as the heat spreader to reinforce the heat spreading module.

The reinforcing frame may include at least one horizontal section extending horizontally and at least one vertical section extending vertically.

The at least one horizontal section may include a pair of horizontal sections arranged in parallel to be vertically spaced from each other, the at least one vertical section may include one vertical section having an upper end and a lower end respectively connected to centers of the pair of horizontal sections, and the heat spreading module may include a plurality of heat spreaders, including the heat spreader, connected to each other in a widthwise direction of the heat spreader and disposed between the pair of the horizontal sections.

The at least one horizontal section may include a plurality of horizontal sections arranged in parallel to be vertically spaced from each other, the at least one vertical section may include one vertical section having an upper end and a lower end respectively connected to centers of a pair of the horizontal sections, and the heat spreading module may include a plurality of heat spreaders, including the heat spreader, disposed alternately with the horizontal sections.

In one example, there is provided a display apparatus including: a display panel which displays an image on a front surface thereof, the display panel being an organic light emitting diode (OLED) panel; a heat spreading module having a shape corresponding to the display panel to support a rear surface, opposite the front surface, of the display panel and to distribute heat generated by the display panel; and at least one printed circuit board on a rear surface of the heat spreading module.

In one example, there is provided a display apparatus including: a display panel which displays an image on a front side thereof; and a heat spreading module on a rear side, opposite the front side, of the display panel and including a heat spreader including a working fluid therein and at least one channel provided therein to guide the working fluid, wherein the heat spreading module distributes heat generated by the display panel on a front side of the heat spreading module, and distributes heat generated on a rear side, opposite the front side, of the heat spreading module.

### BRIEF DESCRIPTION OF THE DRAWINGS

The above and/or other aspects will become apparent and more readily appreciated from the following description of exemplary embodiments, taken in conjunction with the accompanying drawings of which:

FIG. 1 is an exploded perspective view showing a configuration of a display apparatus according to an exemplary embodiment;

FIG. 2 is a cross sectional view illustrating a heat spreader applied to a display apparatus according to an exemplary embodiment;

FIG. 3 is a perspective view illustrating a heat spreading module applied to a display apparatus according to an exemplary embodiment;

FIG. 4 is a partially enlarged perspective view illustrating installation of a heat spreader applied to a display apparatus according to an exemplary embodiment; and

FIGS. 5 to 9 are perspective views illustrating heat spreading modules applied to a display apparatus according to one or more exemplary embodiments.

### DETAILED DESCRIPTION OF EXEMPLARY EMBODIMENTS

Reference will now be made in detail to exemplary embodiments, examples of which are illustrated in the accompanying drawings, wherein like reference numerals refer to like elements throughout.

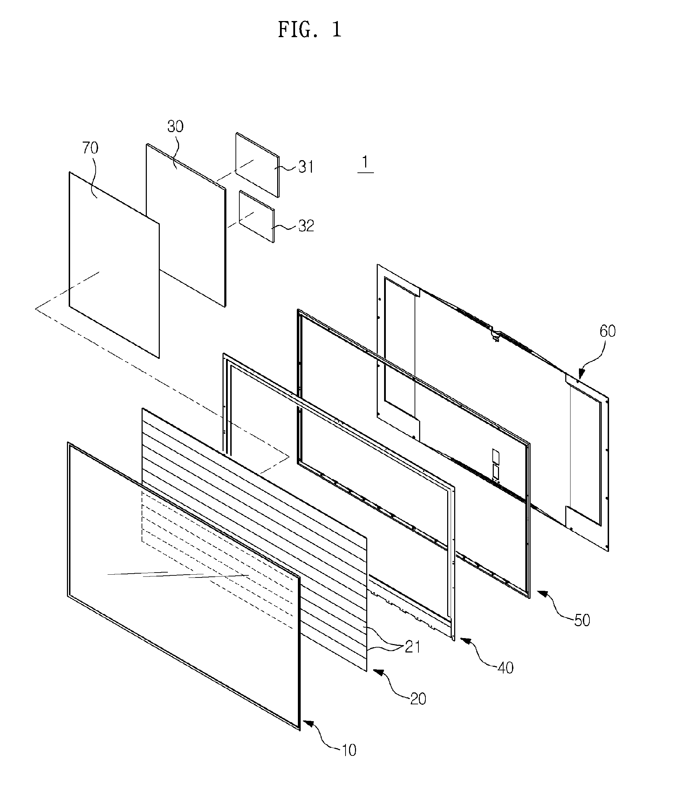

FIG. 1 is an exploded perspective view showing a configuration of a display apparatus 1 according to an exemplary embodiment. In one example, the display apparatus is a television. As shown in FIG. 1, a display apparatus 1 includes a display panel 10 which is disposed to have an exposed front surface and on which an image is displayed, and a rear cover 60 disposed behind the display panel 10 to form a rear appearance of the display apparatus 1.

The display panel 10 according to the present exemplary embodiment is an organic light emitting diode (OLED) panel, and is divided into an active area, where images are displayed, and an inactive area, where images are not displayed.

The active area of the display panel 10 is provided with a plurality of thin film transistors on a glass substrate, and each of the thin film transistors is provided thereon with a liquid crystal layer or an organic layer to form a pixel. Images are displayed on the active area through on/off control of the transistors.

A heat spreading module 20 is disposed between the display panel 10 and the rear cover 60. The heat spreading module 20, which is adapted to allow generated heat to be distributed therethrough and easily dissipated into air, is formed to have a shape of a plate and an area corresponding to that of the display panel such that the front surface of the heat spreading module 20 closely contacts and supports the rear surface of the display panel 10.

When the heat spreading module 20 has a strength greater than or equal to a specific strength to support the rear surface of the display panel 10 as described above, the heat spreading module 20 operates as a reinforcing member that reinforces the display panel 10.

A holder 30 to which various printed circuit boards 31 and 32 are mounted is combined with the back of the heat spreading module 20. Disposed between the holder 30 and the heat spreading module 20 is a heat dissipation sheet 70 formed of a material having a high rate of heat transfer to ensure that heat generated by the printed circuit boards 31 and 32 is transferred more effectively to the heat spreading module 20.

The printed circuit boards 31 and 32 installed (i.e., provided) at the holder 30 may include a power supply board 31 connecting an external power source to the display apparatus 1 and including a switched mode power supply (SMPS), a main board 32 to generate an signal of an image to be displayed on the display panel 10, and a signal transmission board that transmits a generated signal of an image from the main board 32 to the display panel 10.

As described above, since the front surface of the heat spreading module 20 closely contacts the display panel 10, heat generated by the display panel 10 may be transferred to the heat spreading module 20 and dissipated into the air through the rear surface of the heat spreading module 20, and thus the heat from the display panel 10 may be effectively dissipated. That is, the heat spreading module 20 in accordance with the present embodiment causes heat generated not only by the printed circuit boards 31 and 32, but also by the display panel 10, to be dissipated.

The heat spreading module 20 includes a heat spreader 21 which operates to distribute heat such that the heat is easily dissipated.

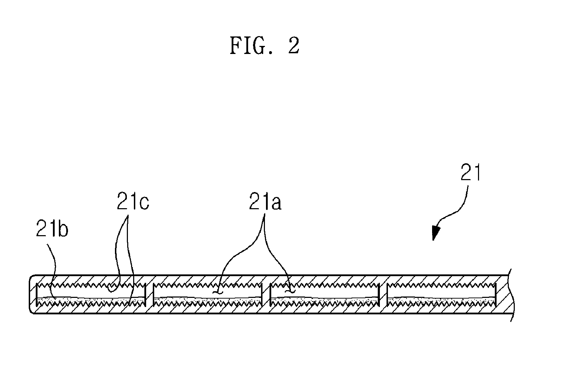

The heat spreader 21 is formed to have a plate shape having a width and a length greater than the width, and is provided therein with at least one channel 21a adapted to guide movement of a working fluid injected into the heat spreader 21, as shown in FIG. 2. The at least one channel 21a extends in the longitudinal direction of the heat spreader 21, and a plurality of the channels 21a is arranged in parallel in the widthwise thereof. Also, a plurality of protrusions 21c extending in the longitudinal direction of the heat spreader 21 is provided on the wall of each channel 21a to facilitate movement of the working fluid 21b. In addition, the heat spreader 21 may be formed of (i.e., include) an aluminum material, and acetone may be used as the working fluid 21b since acetone does not easily oxidize aluminum when changing from liquid phase to gas phase. According to an exemplary embodiment, the working fluid 21b which is in a liquid phase in a first end of the heat spreader 21 absorbs heat and is vaporized. The vaporized working fluid 21b is moved along the plurality of channels 21a to a second end of the heat spreader 21, opposite the first end, by a density difference. While moved to the second end and after reaching the second end, the working fluid 21b in the gas phase loses heat and condenses to return to the first end at lower positions by a weight thereof. Thereby, the working fluid 21b is allowed to circulate rapidly, and thus the distribution of heat by the heat spreader 21 is rapidly implemented.

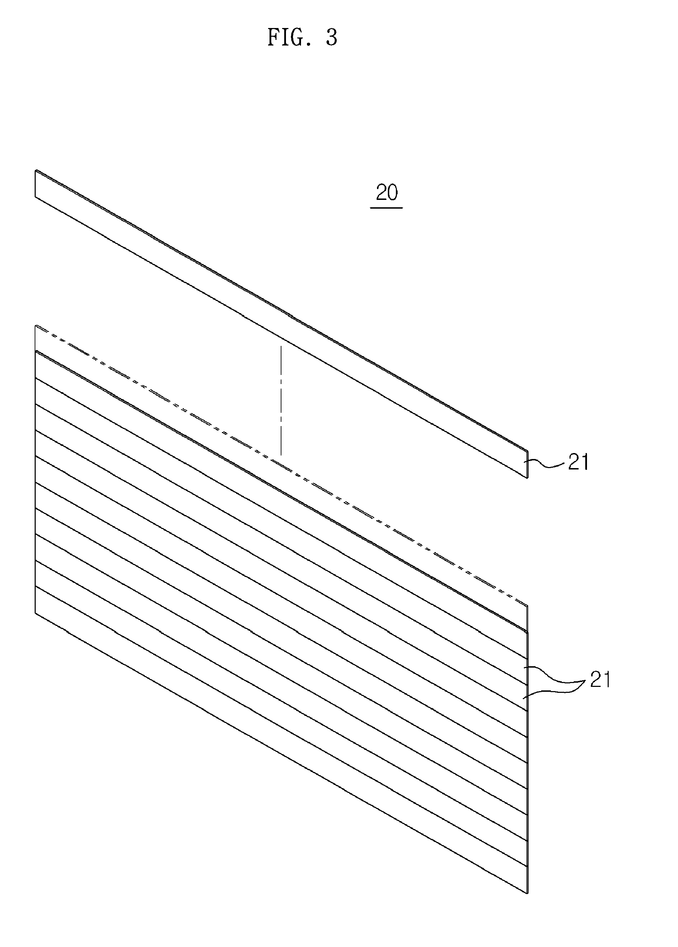

A plurality of such heat spreaders 21 is connected to each other in the widthwise direction thereof to have a shape corresponding to the display panel 10 and, thus, forms the heat spreading module 20. That is, as shown in FIG. 3, each heat spreader 21 has a length corresponding to (or substantially corresponding to) the lateral (e.g., horizontal) width of the display panel 10, and a plurality of the heat spreaders 21 is connected to each other in the widthwise direction thereof to correspond to (or substantially corresponding to) the vertical width of the display panel 10 such that the heat spreading module 20 has a shape corresponding to the display panel 10.

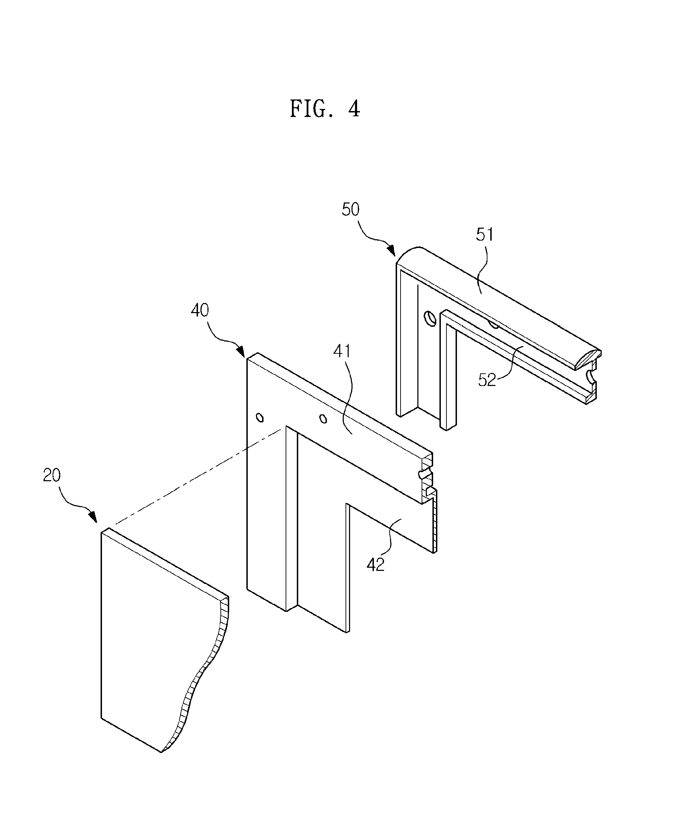

Provided between the display panel 10 and the rear cover 60 is a bracket 40 that presses the front surface of the heat spreading module 20 against the rear surface of the display panel 10. The bracket 40 is attached to the display panel 10 and the heat spreading module 20 by an adhesive material such as double-sided tape or any other type of adhesive. As shown in FIG. 4, the bracket 40 includes a first combining portion 41 attached to the display panel 10 and a second combining portion 42 attached to the heat spreading module 20.

The first combining portion 41 is attached to the display panel 10 at the portions of the display panel 10 beyond the outer edge of the heat spreading module 20 to reinforce the edge of the display panel 10. In addition, the first combining portion 41 is arranged to have an edge matching the edge of the display panel 10 or protrude beyond the edge of the display panel 10 to protect the edge of the display panel 10.

The second combining portion 42, disposed between the heat spreading module 20 and the rear cover 60, is attached to the rear surface of the heat spreading module 20, and presses the heat spreading module 20 against the display panel 10 such that the heat spreading module 20 closely contacts the display panel 10, and thereby heat generated by the display panel 10 may be effectively transferred to the heat spreading module 20.

Further, the display apparatus 1 includes a side cover 50 forming the outer edge of the display apparatus 1. The side cover 50 includes an edge 51 disposed outside the edges of all the components from the display panel 10 to the rear cover 60 to form the outer appearance of the display apparatus 1, and a support 52 extending inward from the edge 51 to support the rear surface of the bracket 40.

In the present exemplary embodiment, the heat dissipation sheet 70 is disposed between the holder 30 and the heat spreading module 20. However, it is understood that one or more other exemplary embodiments are not limited thereto. For example, according to another exemplary embodiment, the heat dissipation sheet 70 may be omitted. In this case, the holder 30 may be formed of a material having a high rate of heat transfer such that the holder 30 may perform the operation of the heat dissipation sheet 70.

In addition, in the present exemplary embodiment, the printed circuit boards 31 and 32 are installed at the heat spreading module 20 through the holder 30. However, it is understood that one or more other exemplary embodiments are not limited thereto. For example, according to another exemplary embodiment, screwing portions to which screws are fastened may be formed (i.e., provided) at the heat spreading module 20 so that the printed circuit boards 31 and 32 are directly installed at the heat spreading module 20 with the screws.

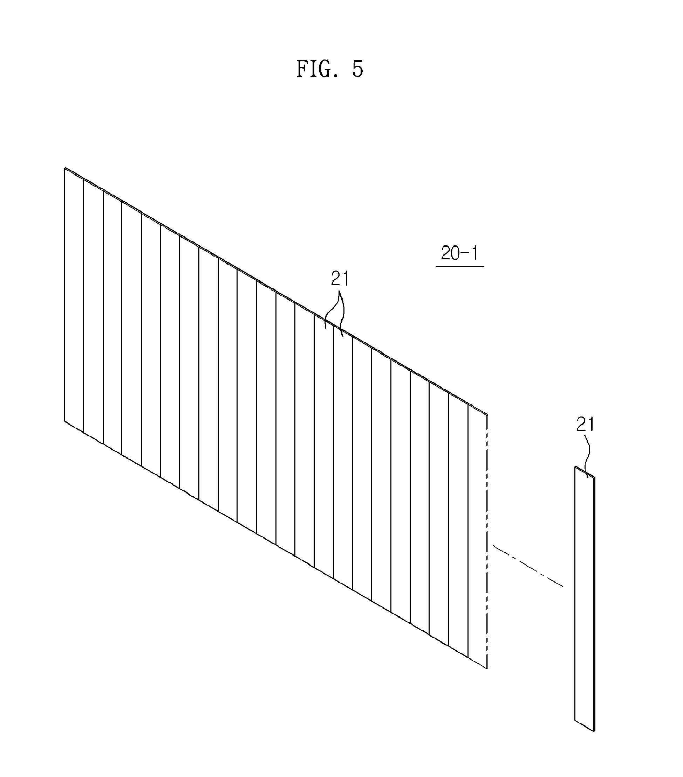

Hereinafter, a heat spreading module 20 according to one or more exemplary embodiments will be described in detail with reference to FIGS. 5 to 9.

In the exemplary embodiment shown in FIG. 5, the heat spreading module 20-1 is configured with the heat spreaders 21 which has a length corresponding to (or substantially corresponding to) the vertical width of the display panel 10, and a plurality of the heat spreaders 21 is connected to each other in the widthwise direction thereof to correspond to (or substantially correspond to) the lateral width of the display panel 10 to have a shape corresponding to the display panel 10.

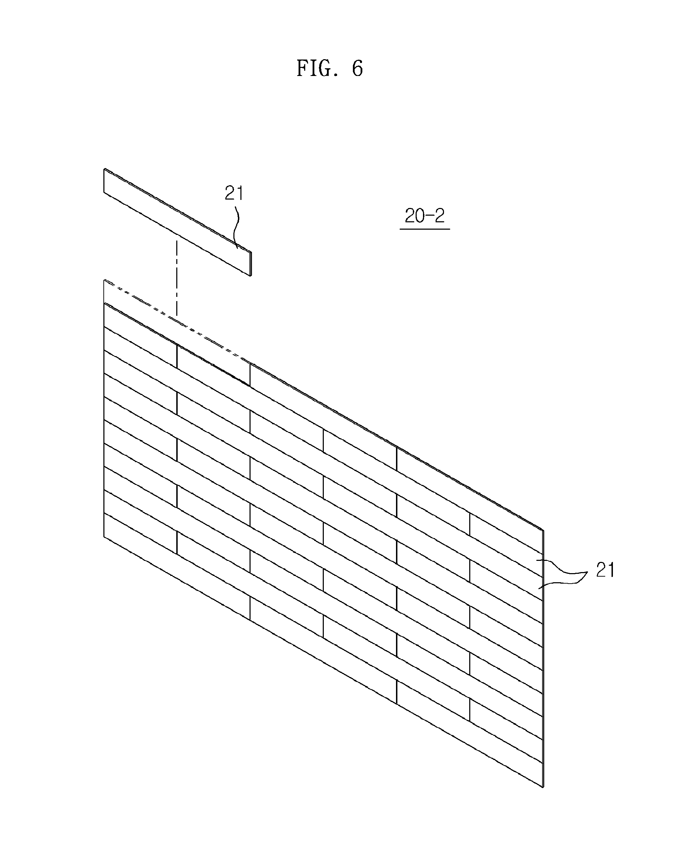

In another exemplary embodiment shown in FIG. 6, the heat spreading module 20-2 includes a plurality of heat spreaders 21 connected to each other in the longitudinal direction thereof to form an array having a length corresponding to (or substantially corresponding to) the lateral width of the display panel 10. Furthermore, a plurality of arrays formed by a plurality of the heat spreaders 21 is connected to each other in the widthwise direction thereof to have a width corresponding to (or substantially corresponding to) the vertical width of the display panel 10 to have a shape corresponding to the display panel 10. In the arrays, portions where the heat spreaders 21 are connected to each other may have relatively low rigidity, compared to other portions of the arrays. To compensate for such low rigidity, the arrays are connected to each other such that the portions in an array where the heat spreaders 21 are connected in the longitudinal direction thereof are misaligned with the portions in a neighboring array where the heat spreaders 21 are connected.

The heat spreading modules 20, 20-1 and 20-2 are described above as including only the heat spreaders 21. However, when the heat spreading module 20 include only the heat spreaders 21, the heat spreading module 20 may not have sufficient strength depending on a material of the heat spreader 21, and thus may fail to support the display panel 10.

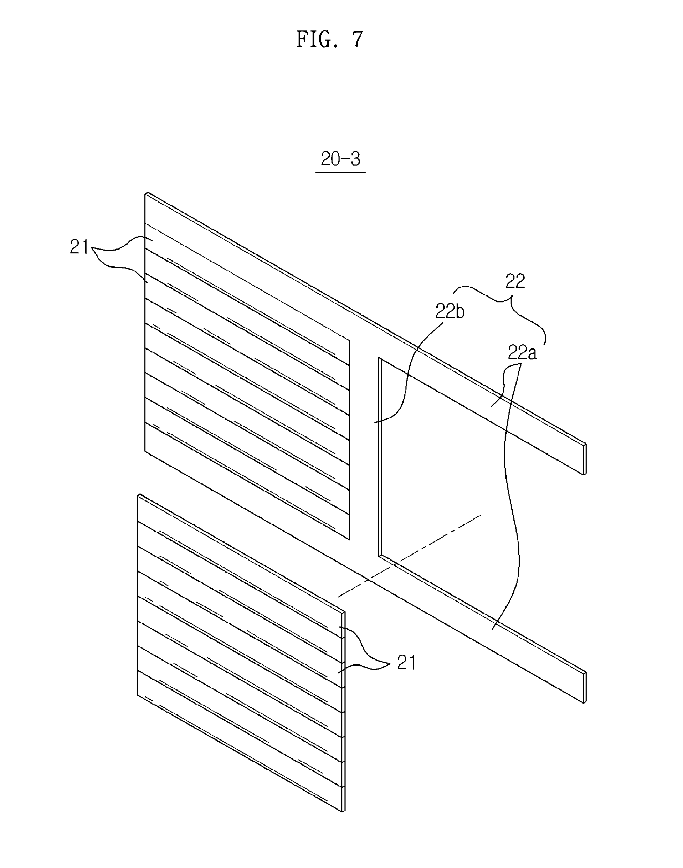

Accordingly, to provide sufficient strength, it may be possible, as shown in FIGS. 7 to 9, that the heat spreading modules 20-3, 20-4 and 20-5 include a plurality of the heat spreaders 21 and reinforcing frames 22, 22' and 22" which are formed of a material having a higher strength than the heat spreaders 21 in order to support the heat spreaders 21.

The reinforcing frames 22, 22' and 22" applied to the heat spreading modules 20-3, 20-4 and 20-5 include at least one horizontal section 22a extending horizontally and at least one vertical section 22b extending vertically.

In an exemplary embodiment shown in FIG. 7, the heat spreading module 20-3 includes a reinforcing frame 22 including a pair of horizontal sections 22a spaced from each other and a vertical section 22b connecting centers of the two horizontal sections 22a, and a plurality of heat spreaders 21 connected to each other in the widthwise direction thereof and installed (i.e., provided) at a space between the two horizontal sections 22a.

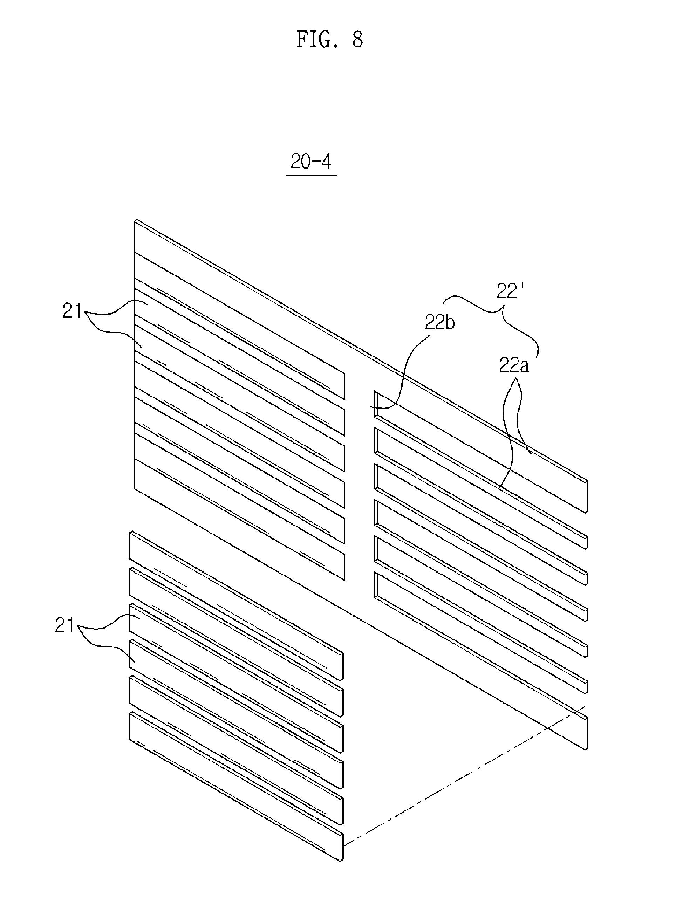

In another exemplary embodiment shown in FIG. 8, the heat spreading module 20-4 includes a reinforcing frame 22' including a plurality of horizontal sections 22a spaced from each other and a vertical section 22b connecting centers of the plurality of the horizontal sections 22a, and a plurality of heat spreaders 21 disposed alternately with the plurality of horizontal sections 22a.

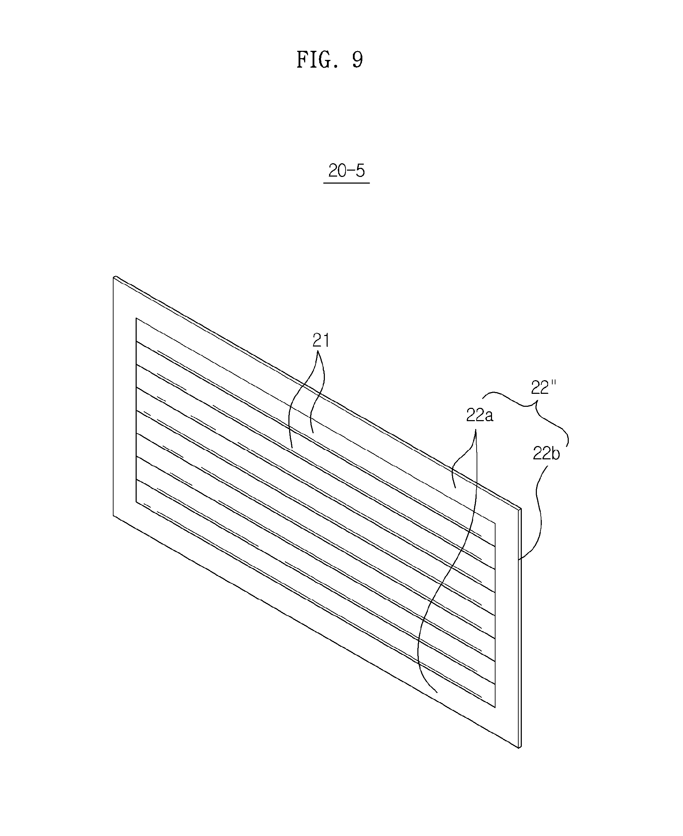

In a further exemplary embodiment shown in FIG. 9, the heat spreading module 20-5 includes a reinforcing frame 22" including a pair of horizontal sections 22a spaced from each other and a pair of vertical section 22b connecting opposite ends of the two horizontal sections 22a to form a rectangular shape, and a plurality of heat spreaders 21 connected to each other in the widthwise direction thereof and installed inside the reinforcing frame 22".

As is apparent from the above description, since a heat spreading module of a plate shape provided to distribute heat supports the display panel directly, heat generated not only by a printed circuit board but also by the display panel is distributed through the heat spreading module and dissipated, and thus heat dissipation may be performed more efficiently.

Although a few embodiments have been shown and described, it will be appreciated by those skilled in the art that various changes and modifications might be made without departing from the scope of the invention, as defined in the appended claims.

## Claims

1. A display apparatus, comprising:
a display panel (10) which displays an image on a front surface thereof; and
a heat spreading module (20) having a shape corresponding to the display panel (10) to support a rear surface of the display panel (10);
wherein the heat spreading module (20) comprises at least one heat spreader (21) including a working fluid (21b) therein and at least one channel (21a) provided therein to guide the working fluid (21 b).

2. The display apparatus according to claim 1, wherein the display panel (10) is an organic light emitting diode, OLED, panel.

3. The display apparatus according to claim 1, further comprising at least one printed circuit board (31, 32) arranged on a rear surface of the heat spreading module (20).

4. The display apparatus according to claim 1, wherein the heat spreader (21) is elongate having a length greater than its width.

5. The display apparatus according to claim 1, wherein the heat spreading module (20) comprises a plurality of the heat spreaders (21) which are connected to each other in a widthwise direction thereof.

6. The display apparatus according to claim 5, wherein:
a length of the heat spreading module (20) corresponds to a horizontal width of the display panel (10); and
the plurality of the heat spreaders (21) are vertically connected to each other to correspond to a vertical height of the display panel (10).

7. The display apparatus according to claim 5, wherein:
the plurality of heat spreaders (21) have a length corresponding to a vertical height of the display panel (10); and
the plurality of the heat spreaders (21)are connected to each other in the widthwise direction thereof to correspond to a horizontal width of the display panel (10).

8. The display apparatus according to claim 5, wherein:
first heat spreaders (21), are connected to each other in a longitudinal direction, perpendicular to the widthwise direction, thereof to form an array having a length corresponding to a horizontal width of the display panel (10);
the heat spreading module (20) includes a plurality of such arrays of the heat spreaders (21) connected to each other in the longitudinal direction thereof , the plurality of arrays being connected to each other in the widthwise direction to correspond to a vertical width of the display panel (10); and
the plurality of arrays are connected such that connecting portions in which the heat spreaders (21) are connected in one of the arrays are misaligned with connecting portions in an adjacent one of the arrays.

9. The display apparatus according to claim 1, wherein the at least one channel (21a) extends in a longitudinal direction of the heat spreader (21), and the heat spreading module (20) comprises a plurality of the heat spreaders (21)which are arranged in parallel in a widthwise direction of the heat spreaders (21).

10. The display apparatus according to claim 1, wherein the heat spreading module (20) further comprises a reinforcing frame (22) on a same plane as the heat spreader (21) to reinforce the heat spreading module (20).

11. The display apparatus according to claim 10, wherein the reinforcing frame (22) comprises at least one horizontal section (22a) extending horizontally and at least one vertical section (22b) extending vertically.

12. The display apparatus according to claim 11, wherein:
the reinforcing frame (22) includes a pair of the horizontal sections (22a) arranged in parallel to be vertically spaced from each other;
the reinforcing frame (22) includes one vertical section (22b) having an upper end and a lower end respectively connected to centers of the pair of the horizontal sections (22a); and
the heat spreading module (20) comprises a plurality of the heat spreaders (21) connected to each other in a widthwise direction of the heat spreader and disposed between the pair of horizontal sections (22a).

13. The display apparatus according to claim 11, wherein:
a plurality of the horizontal sections (22a) are arranged in parallel to be vertically spaced from each other;
one vertical section (22b) has an upper end and a lower end respectively connected to centers of a pair of the horizontal sections; and
the heat spreading module comprises a plurality of the heat spreaders (21) disposed alternately with the horizontal sections (22a).

14. The display apparatus according to any preceding claim, wherein a front surface of the heat spreading module (20) faces the display panel (10) to distribute heat generated by the display panel (10), and a rear surface of the heat spreading module (20) faces at least one printed circuit board (31, 32) to distribute heat generated by the at least one printed circuit board (31, 32).

15. The display apparatus according to any preceding claim, wherein the heat spreader (21) comprises aluminum, and the working fluid comprises acetone.
